Europäisches Patentamt

European Patent Office

Office européen des brevets

(11) Veröffentlichungsnummer: **0 295 365 B1**

(12) **EUROPÄISCHE PATENTSCHRIFT**

(45) Veröffentlichungstag der Patentschrift: **04.11.92**

(21) Anmeldenummer: **88103113.2**

(22) Anmeldetag: **02.03.88**

(51) Int. Cl.5: **H01L 27/14**, H01L 31/10

(54) **Halbleiter mit kapazitiver Auslese der Ladungsträger und integrierter Gleichspannungszuführung.**

(30) Priorität: **11.05.87 DE 3715674**

(43) Veröffentlichungstag der Anmeldung:
**21.12.88 Patentblatt 88/51**

(45) Bekanntmachung des Hinweises auf die
Patenterteilung:
**04.11.92 Patentblatt 92/45**

(84) Benannte Vertragsstaaten:
**CH DE FR GB LI NL**

(56) Entgegenhaltungen:
**EP-A- 0 216 426**
**DE-A- 2 942 159**
**DE-B- 2 804 466**
**US-A- 3 676 715**

**NUCLEAR INSTRUMENTS & METHODS IN
PHYSICS RESEARCH. vol. A235, no. 3, 01
April 1985, AMSTERDAM NL Seiten 481 - 487;
U. Kötz et al: "Silicon strip detectors with
capacitive charge division"**

**PATENT ABSTRACTS OF JAPAN vol. 9, no.
169 (E-328)(1892) 13 Juli 1985, & JP-A-60
042988 (MITSUBISHI) 07 März 1985,**

(73) Patentinhaber: **Messerschmitt-Bölkow-Blohm**

Gesellschaft mit beschränkter Haftung
Robert-Koch-Strasse
W-8012 Ottobrunn(DE)

Patentinhaber: **Lutz, Gerhard, Dr.**
**Therese-Giehse-Allee 23**
**W-8000 München 83(DE)**

Patentinhaber: **Holl, Peter**
**Dürerstrasse 2a**
**W-8018 Grafing(DE)**

Patentinhaber: **Strüder, Lothar**
**Türkenstrasse 33**
**W-8000 München 40(DE)**

(72) Erfinder: **Kemmer, Josef, Dr.**
**Hauptstrasse 41D**
**W-8048 Haimhausen(DE)**
Erfinder: **Lutz,Gerhard,Dr.**
**Therese-Giehse-Allee 23**
**W-8000 München 83(DE)**
Erfinder: **Holl,Peter**
**Dürerstrasse 2A**
**W-8018 Grafing(DE)**
Erfinder: **Strüder,Lothar**
**Türkenstrasse 33**
**W-8000 München 40(DE)**

## Beschreibung

Die Erfindung bezieht sich auf einen Halbleiterdetektor mit Streifenstruktur und einem verarmten Grundgebiet gemäß dem Oberbegriff des Patentanspruchs 1.

Bei Halbleiterdetektoren dieser Art, die allgemein bekannt sind, ist es möglich, sowohl Majoritäts- als auch Minoritätsladungsträger auszulesen. Besonderes Interesse haben Streifendetektoren gefunden, bei denen eine Vielzahl von gegeneinander elektrisch isolierten Streifenelektroden eine Positionsmessung erlauben.

In der Regel wird das Signal vom Detektor direkt oder über externe Kapazitäten an die Elektronik übertragen. Die kapazitive Ankoppelung hat den Vorteil, daß unerwünschte Dunkelströme des Detektors von der Elektronik ferngehalten werden. Die kapazitive Ankoppelung von integrierter Ausleseelektronik mit hoher Auslesedichte ist bei den bekannten Halbleiterdetektoren schwierig, wenn nicht unmöglich, da die dazu benötigten großen Koppelungskapazitäten und hochohmigen Widerstände mit vernünftigem Aufwand nicht in die Elektronik integriert werden können.

Aus Dokument JP-A-60 042 988 ist eine Halbleitervorrichtung als Bildaufnehmer bekannt, die eine MIS-Struktur mit N-Gebiet aufweist, zusätzlich zu einer konventionellen pn-Verbindung, um die Menge der gespeicherten Ladung zu vergrößern. Für die pn-Verbindung wird eine Silizium-Nitrid-Schicht benutzt, die eine große Kapazität aufweist. Diese Konstruktion/dieser Aufbau der Halbleitervorrichtung kann zu ungünstigen Leckströmen führen. Diese MIS-Struktur läßt sich außerdem schlecht verarmen.

Aus Dokument US-A-3 676 715 und EP-A-0 216 426 (siehe Spalte 9, Absatz 1 und 2) ist eine Halbleitervorrichtung bekannt, welche den gleichen prinzipiellen Aufbau aufweist, wie diejenige nach Dokument JP-A-60 042 988 und somit auch die gleichen Nachteile aufweist.

Dokument Nuclear Instruments & Methods in Physics Research, vol. A 235, no. 3, 1. April 1985, Amsterdam NL, Seiten 481 - 487; U. Kötz et al. kennzeichnet den Stand der Technik, von dem die Erfinder ausgingen.

Der Erfindung liegt die Aufgabe zugrunde, einen Halbleiterdetektor gemäß dem Oberbegriff des Anspruchs 1 derart weiterzubilden, daß eine kapazitive Ankoppelung auch bei komplexen Aufbau möglich ist.

Eine erfindungsgemäße Lösung dieser Aufgabe ist mit ihren Weiterbildungen in den Patentansprüchen gekennzeichnet.

Die Erfindung wird nachstehend anhand von Ausführungsbeispielen unter Bezugnahme auf die Zeichnung näher beschrieben, in der zeigen:

| Fig. 1 | einen Querschnitt durch ein erstes Ausführungsbeispiel der Erfindung mit Auslese der Minoritätsträger, |
| Fig. 2 | einen Querschnitt durch ein zweites Ausführungsbeispiel mit Auslese der Majoritätsträger, |
| Fig. 3 und 4 | Modifikationen der in Fig. 1 und 2 gezeigten Ausführungsbeispiele mit Isolationsstrukturen, |
| Fig. 5 | ein weiteres Ausführungsbeispiel mit Majoritätsträgerauslese, |
| Fig. 6 | eine Aufsicht auf eine Streifenstruktur, |
| Fig. 7 | eine segmentierte Streifenstruktur, und |
| Fig. 8 | einen Längsschnitt durch eine segmentierte Streifenstruktur. |

Erfindungsgemäß sind die Ankoppelungskapazität in den Detektor integriert, während die Spannungszuführung über eine nahe der Ausleseelektrode angebrachte Elektrode gleicher Leitfähigkeit erfolgt. Die Integration der Koppelungskapazität wird durch Zwischenlegen einer isolierten Schicht in der Ausleseelektrode zwischen dem hochdotierten Teil und der Metallisierung erreicht. Bei der Spannungszuführung macht man sich die Tatsache zunutze, daß nahe beieinander liegende Elektroden der gleichen Leitfähigkeit nur bei kleinen Spannungsunterschieden elektrisch voneinander getrennt sind. Übersteigt diese Spannung einen bestimmten Wert, so fließt ein Strom zwischen den beiden Elektroden der mit zunehmender Spannung ungefähr exponentiell ansteigt.

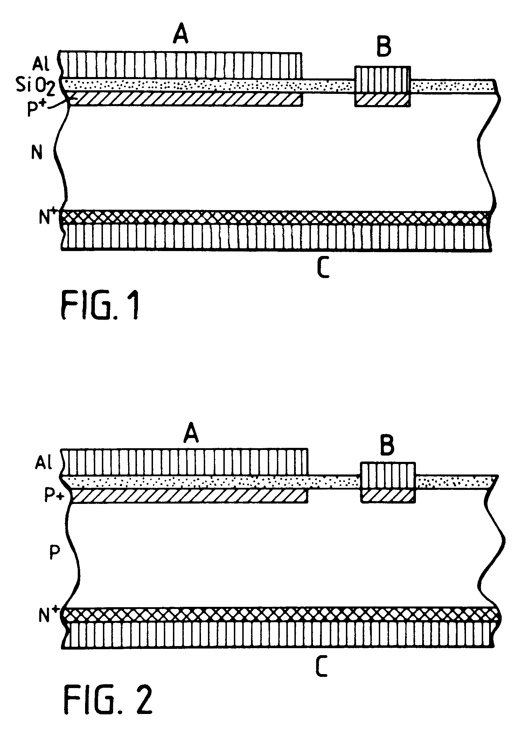

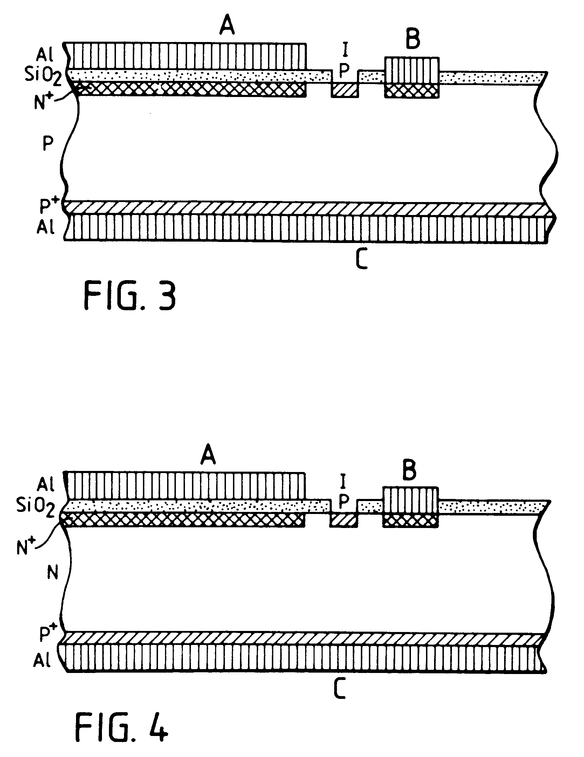

Legt man also z.B. bei der Anordnung in Fig. 1 eine Biasspannung zwischen spannungszuführender Elektröde (B) und der gegenüberliegenden Seite des Detektors (C) an, so wird sich der dotierte Teil der Ausleseelektrode (A) selbständig auf ein von der spannungszuführenden Elektrode leicht verschiedenes Potential einstellen. Die Potentialdifferenz ist unter anderem bestimmt durch den Elektrodenabstand und die Oxydladung. Die Anordnung zur Auslese von Majoritätsträgern in Fig. 2 funktioniert völlig analog jedoch erst bei Anlagen genügend hoher Bias-Spannung zur vollständigen Verarmung des Detektorvolumens.

Eine gewisse Komplikation ergibt sich bei Verwendung von N-Material und Majoritätsträgerauslese bzw. bei P-Material und Minoritätsträgerauslese, da die positiven Oxidladungen an der $Si-SiO_2$ Grenzfläche eine elektrische Verbindung zwischen Ausleseelektroden untereinander und den spannungszuführenden Elektroden bewirkt. Dieses Problem läßt sich jedoch beispielsweise durch Zwischenlegen von isolierenden P-Gebieten (I) (Fig. 3 und 4) oder geeignet vorgespannter MOS-Strukturen (M) (Fig.5) umgehen.

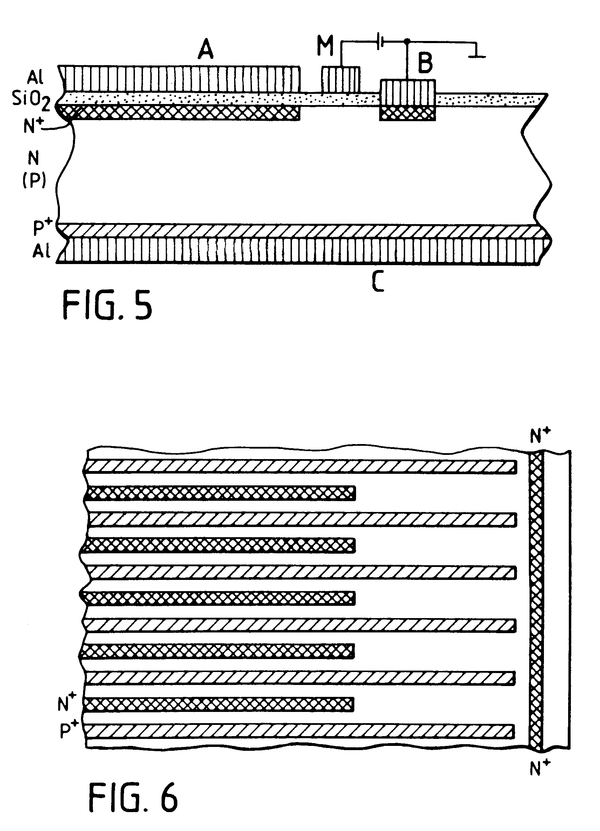

Weiterhin ist es möglich, den relativ hohen Quadratwiderstand der Elektronen-Akkumulations (Inversions)-Schicht zur Ausbildung eines Vorwiderstands zu verwenden. Dies ist in Fig. 6 für einen Streifendetektor auf N-Material mit Majoritätsträgerauslese gezeigt. Die P-Streifen dienen der Isolation zwischen den $N^+$-Ausleseelektroden und überragen diese in der Länge, so daß die lange Akkumulationsschicht zwischen den P-Streifen den Bias-Widerstand bildet.

Die oben angeführten Ausführungsformen, deren Merkmale in den Patentansprüchen 1 bis 5 benasprucht sind, haben außer der bereits erwähnten Integration der Kopplungskapazitäten in den Detektor den Vorteil, daß auf die Ausbildung von Widerständen durch zusätzliche technologische Schritte, wie z.B. Fabrikation von Polysilizium-Widerständen, verzichtet werden kann.

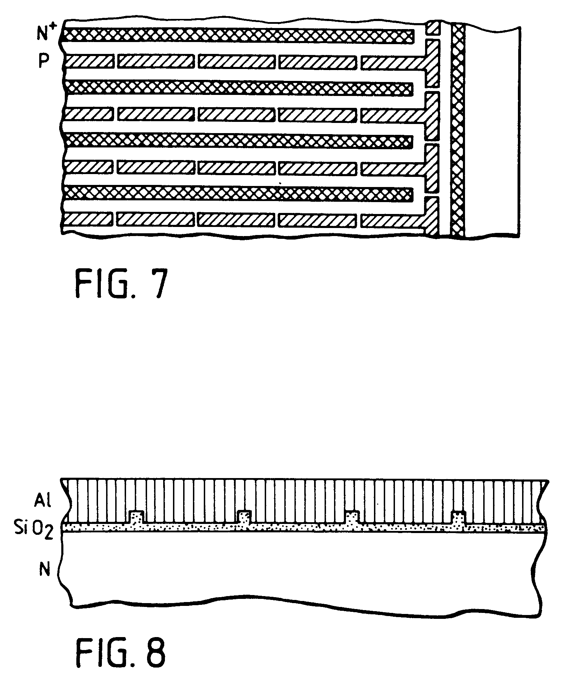

Die in Ansprüchen 6 und 7 (Ausführungsbeispiele Fig. 7 und 8) enthaltenen Weiterbildungen sind bei inhomogener Dotierung des Grundkörpers von Vorteil. Da sich die einzelnen Segmente der Isolationsstruktur auf unterschiedliche Spannungen einstellen können, wird die elektrische Isolation schon bei kleineren Spannungen erreicht und die elektrischen Felder werden verringert.

Die in den Ansprüchen 8 und 9 enthaltenen Ausführungen führen zu einem positionsempfindlichen Detektor, mit Anspruch 10 ist überdies ein einfaches Testen des Detektors möglich, da von einer einzelnen spannungszuführenden Elektrode mehrere (oder alle) Ausleseelektroden gleichzeitig mit Spannung versorgt werden können. Weiterhin erlaubt diese Anordnung eine wesentliche Vereinfachung bei Anwendung der Auslese mit kapazitiver Ladungsteilung. Dies bedeutet den Anschluß von Elektronik an ausgewählte Ausleseelektroden, im allgemeinen in regelmäßigen Abständen.

Es ist dabei erforderlich, auch die nicht ausgelesenen Elektroden auf das gleiche Potential zu bringen. was normalerweise durch Aufbringen hochohmiger Widerstandsschichten erfolgt. Diese können bei einer Anordnung nach Anspruch 10 entfallen.

Besonders interessant ist die Weiterbildung nach Anspruch 11. Die gleichzeitige Verwendung von beiden Sorten von Ladungsträgern als Signal erlaubt z.B. bei streifenförmiger Ausbildung der Ausleseelektroden auf beiden Hauptebenen die gleichzeitige Messung von zwei unabhängigen Koordinaten mit nur einem Detektor.

Vorstehend sind Ausführungsbeispiele ohne Beschränkung der Allgemeinheit beschrieben worden. Selbstverständlich sind im Rahmen des allgemeinen Erfindungsgedanken die verschiedensten Modifikationen möglich. So die Verwendung anderer Halbleitermaterialien, Isolatoren und Leiter. So können z.B. Aluminium durch Polysilizium, Siliziumoxyd durch Siliziumnitrit und bipolare Dioden durch Schottky-Dioden ersetzt werden. Auch in der Geometrie ergeben sich weite Variationsmöglichkeiten, wie z.B. Zylinder-Geometrie. Mäander-Strukturen oder Ersetzung der Streifenstruktur durch Pad-Strukturen. Auch eine serielle Spannungsversorgung von Ausleseelektroden anstelle oder zusätzlich zu der in den Ausführungsbeispielen beschriebenen Parallelen ist möglich. Bei Ausnutzung der Elektronen-Akkumulations-oder Inversions-Schicht (Fig. 7) kann der Wert des Vorwiderstandes durch Veränderung der Breite oder Form der Isolationsstruktur im Endbereich verändert werden.

**Patentansprüche**

1. Halbleiterdetektor mit Streifenstruktur und einem verarmten Grundgebiet einer ersten Leitfähigkeit, an das eine Vorspannung angelegt ist, sowie mindestens einer Ausleseelektrode, an der die durch die einfallende Strahlung erzeugten Ladungsträger ein Signal erzeugen, **gekennzeichnet** durch folgende Merkmale:

    a) die Ausleseelektrode besteht aus einem hochdotiertem Gebiet einer ersten oder einer zweiten Leitfähigkeit, auf dem eine Isolationsschicht und darauf eine leitende Elektrodenschicht aufgebracht ist, an der die influenzierten Signale abnehmbar sind,

    b) die Ausleseelektrode Weist eine solche Streifenstruktur auf, die nur das hochdotierte Gebiet der einen Leitfähigkeit beinhaltet, und

    c) die Spannungsführung an das hochdotierte Gebiet der Ausleseelektrode erfolgt hochohmig über das Grundgebiet des Detektors von mindetsens einer Elektrode der gleichen Leitfähigkeit wie die Ausleseelektrode.

2. Detektor nach Anspruch 1, **dadurch gekennzeichnet,** daß zur elektrischen Trennung der Elektroden die Ausleseelektrode(n) durch Gebiete anderer Leitfähigkeit vollständig oder teilweise umschlossen sind.

3. Detektor nach Anspruch 1, **dadurch gekennzeichnet,** daß zur elektrischen Trennung der Elektroden die Ausleseelektrode(n) durch geeignet vorgespannte MOS-Strukturen vollständig oder teilweise umschlossen sind.

4. Detektor nach Anspruch 1, **dadurch gekennzeichnet,** daß zur elektrischen Trennung der Elektroden voneinander die Oxidladungen mittels großflächiger Oberflächendotierung kompensiert werden.

5. Detektor nach Anspruch 4, **dadurch gekennzeichnet,** daß die großflächige Oberflächendotierung durch Ionenimplantation hergestellt ist.

6. Detektor nach Anspruch 2, **dadurch gekennzeichnet,** daß die Gebiete anderer Leitfähigkeit segmentiert sind, so daß sie sich auf unterschiedliche Spannungen einstellen können.

7. Detektor nach Anspruch 3, **dadurch gekennzeichnet,** daß die MOS-Strukturen segmentiert sind, so daß sich somit die Inversionsschichten der einzelnen Segmente auf unterschiedliche Spannungen einstellen können.

8. Detektor nach Anspruch 1, **dadurch gekennzeichnet,** daß mehrere Elektroden in Streifenform nebeneinander angeordnet sind.

9. Detektor nach einem der Ansprüche 2 bis 7, **dadurch gekennzeichnet,** daß mehrere Ausleseelektroden und mehrere Gebiete in Streifenform mit Isolationsstrukturen nebeneinander angeordnet sind.

10. Detektor nach Anspruch 9, **dadurch gekennzeichnet,** daß eine Vorspannungszuführung für mehrere Ausleseelektroden von der gleichen, mindestens einen Elektrode in der Elektrodenschicht erfolgt.

11. Detektor nach einem der Ansprüche 1 bis 10, **dadurch gekennzeichnet,** daß nicht nur auf einer ersten Hauptoberfläche, sondern auch auf der dieser abgekehrten Hauptoberfläche wenigstens eine Ausleseelektrode vorgesehen ist.

## Claims

1. Semiconductor detector with strip structure and branched base area of a primary conductivity to which is applied a bias, as well as at least one selector electrode on which the charge carriers produced by incidence radiation produce a signal, **characterised by** the following features:
   a) the selector electrode is composed of a highly doped area of primary and secondary conductivity having in insulating layer and theron a conducting electrode layer on which the influenced signal can be collected;
   b) the selector electrode has a strip structure which only includes the highly doped area of the one conductivity; and
   c) the current ducting to the highly doped area of the selector electrode is high-ohmed over the base area of the detector of at least one electrode of a conductivity equal that of the selector electrode.

2. Detector according to claim 1, **characterised in that,** for the purpose of electrical separation of electrodes, the selector electrode(s) are fully or partially enclosed by areas of another conductivity.

3. Detector according to claim 1, **characterised in that,** for the purpose of electrical separation of the electrodes, the selector electrode(s) are fully or partially enclosed by suitably biassed MOS structures.

4. Detector according to claim 1, **characterised in that,** for the purpose of electrical separation of the electrodes from each other, oxide charges are compensated by means of large area surface doping.

5. Detector according to claim 4, **characterised in that** the large area surface doping is produced by ion implantation.

6. Detector according to claim 2, **characterised in that** the areas of other conductivity are segmented, so that they can adjust to different voltages.

7. Detector according to claim 3, **characterised in that** the MOS structures are segmented, so that the inversion layers of the individual segments can thus adjust to different voltages.

8. Detector according to claim 1, **characterised in that** a plurality of electrodes is arranged alongside each other in the form of strips.

9. Detector according to one of claims 2 to 7, **characterised in that** a plurality of selector electrodes and a plurality of areas in the form of strips are arranged alongside each other with insulation structures.

10. Detector according to claim 9, **characterised in that** bias for a plurality of selector electrodes is supplied by the same, at least one electrode in the electrode layer.

11. Detector according to one of claims 1 to 10, **characterised in that** at least one selector electrode is provided not only on a first main surface, but also on a main surface remote thereof.

## Revendications

**1.** Détecteur à semiconducteur comportant une structure à bandes, un substrat appauvri qui présente une première conductibilité et auquel est appliquée une tension de polarisation ainsi qu'au moins une électrode de lecture au niveau de laquelle les porteurs de charge produits par le rayonnement incident génèrent un signal, caractérisé par les éléments suivants:

a) l'électrode de lecture est constituée par une zone fortement dopée qui présente une première ou une deuxième conductibilité et sur laquelle est appliquée une couche isolante avec sur celle-ci, une couche électrode conductrice à partir de laquelle les signaux influencés sont lus,

b) l'électrode de lecture présente une structure de bande qui contient uniquement la zone fortement dopée de l'une des conductibilités, et

c) la tension est appliquée à la zone fortement dopée de l'électrode de lecture avec une forte valeur ohmique par l'intermédiaire du substrat du détecteur, à partir d'au moins une électrode ayant la même conductibilité que l'électrode de lecture.

**2.** Détecteur selon la revendication 1, caractérisé en ce que, pour séparer électriquement les électrodes, l'électrode ou les électrodes de lecture est (sont) totalement ou partiellement entourée(s) de zones présentant une conductibilité différente.

**3.** Détecteur selon la revendication 1, caractérisé en ce que, pour séparer électriquement les électrodes, l'électrode ou les électrodes de lecture est (sont) totalement ou partiellement entourée(s) de structures MOS avec une polarisation adaptée.

**4.** Détecteur selon la revendication 1, caractérisé en ce que, pour séparer électriquement les électrodes, les charges d'oxydes sont compensées par un dopage superficiel de grande surface.

**5.** Détecteur selon la revendication 4, caractérisé en ce que le dopage superficiel de grande surface est obtenu par implantation ionique.

**6.** Détecteur selon la revendication 2, caractérisé en ce que les zones de conductibilité différente sont découpées en segments de sorte que celles-ci peuvent prendre des tensions différentes.

**7.** Détecteur selon la revendication 3, caractérisé en ce que les structures MOS sont découpées en segments de sorte que les couches d'inversion des différents segments peuvent prendre des tensions différentes.

**8.** Détecteur selon revendication 1, caractérisé en ce que plusieurs électrodes en forme de bande sont disposées côte à côte.

**9.** Détecteur selon l'une des revendications 2 à 7, caractérisé en ce que plusieurs électrodes de lecture et plusieurs zones en forme de bande comportant des structures isolantes sont disposées côte à côte.

**10.** Détecteur selon la revendication 9, caractérisé en ce que la tension de polarisation de plusieurs électrodes de mesure est appliquée à partir de la même électrode, au nombre d'au moins un, de la couche d'électrodes.

**11.** Détecteur selon l'une des revendications 1 à 10, caractérisé en ce qu'il est prévu au moins une électrode de mesure non seulement sur la première surface principale mais aussi sur la surface principale opposée à celle-ci.

**FIG. 1**

**FIG. 2**

FIG. 3

FIG. 4

FIG. 5

FIG. 6

N$^+$

P

## FIG. 7

Al

Si O$_2$

N

## FIG. 8